# EUROPÄISCHE PATENTANMELDUNG

(11) **EP 4 456 683 A1**
(43) Veröffentlichungstag der Anmeldung: **30.10.2024**
(21) Anmeldenummer: 23169543.8
(22) Anmeldetag: 24.04.2023
(51) Int. Cl.: H05K 5/02

(54) **GEHÄUSE ZUM SICHERN VON ZÜNDQUELLEN**

(71) Anmelder: Samcon Prozessleittechnik GmbH, 35102 Lohra-Altenvers (DE)
(72) Erfinder: SEIBERT, Steffen, 35102 Altenvers/Lohra (DE)
(74) Vertreter: Patentanwälte Olbricht Buchhold Keulertz

(57) **Zusammenfassung**

Die vorgestellte Erfindung betrifft ein Gehäuse (100) zum Sichern von Zündquellen, wobei das Gehäuse (100) explosionsdruckfest gegen eine in dem Gehäuse (100) stattfindende Explosion ist, und wobei das Gehäuse (100) umfasst:
- einen Gehäusekörper (101),
- eine in den Gehäusekörper (101) eingebrachte Öffnung (107) zum Verbinden mit einer Kabelleitungseinführung (109, 303),
- eine an dem Gehäusekörper (101) angeordnete Schnittstelle (113, 301) zum Verbinden mit einem durch die Öffnung (107) verlaufenden Kabel (127),

wobei die Schnittstelle (113, 301) zwischen einer Kopplungsstellung und einer Ruhestellung beweglich ist,
wobei die Schnittstelle (113, 301) in der Kopplungsstellung entlang einer Vertikalachse des Gehäusekörpers (101) weiter von einem der Öffnung (107) gegenüberliegenden Ende des Gehäusekörpers (100) entfernt ist als in der Ruhestellung.

## Beschreibung

Die vorgestellte Erfindung betrifft ein Gehäuse zum Sichern von Zündquellen, ein Verbindungsverfahren zum Verbinden einer in einem Gehäuse gesicherten Zündquelle mit einem Kabel, ein Elektroniksystem und ein Gehäuseelement gemäß den beigefügten Ansprüchen.

Zum Sichern von Zündquellen gegen eine Ausbreitung von gezündeten Fluiden, insbesondere Gasen, in eine Umgebung sind verschiedene Schutzarten bekannt, die in entsprechenden Normen, wie "Druckfeste Kapselung", Ex "d" oder "erhöhte Sicherheit", Ex "e" beschrieben werden, die bspw. den Einschluss einer in einem Gehäuseinneren eventuell auftretenden Explosion betreffen. Erreicht wird dieses durch eine explosionsdruckfeste Auslegung eines Gehäuses zusammen mit zünddurchschlagsicheren Spalten an allen Gehäuseöffnungen.

Des Weiteren muss eine Oberflächentemperatur eines Betriebsmittels auch bei Auftreten eines zu erwartenden Fehlers unter die Zündtemperatur der umgebenden explosionsfähigen Atmosphäre begrenzt werden. Die Anforderungen an ein Betriebsmittel sind in der Norm IEC/EN/DIN 60079-0/-1beschrieben.

Insbesondere die Zündschutzart Ex "d" ist auch anzuwenden, wenn im Inneren des Betriebsmittels im ungestörten Betrieb Zündquellen auftreten.

Bei explosionsdruckfesten Gehäusen besteht eine Herausforderung bzgl. der Verkabelung von elektrischen Komponenten, insbesondere zur Versorgung der Komponenten mit elektrischem Strom. Dazu ist gemäß dem Stand der Technik ein separater Anschlussraum in Gehäuse vorgesehen, der von einem Aufnahmeraum zur Aufnahme einer Zündquelle getrennt ist. Entsprechend wird der Anschlussraum geöffnet, eine Verkabelungsschnittstelle, wie bspw. eine Klemme in den Anschlussraum eingebracht und der Anschlussraum wieder geschlossen. Dazu muss der Anschlussraum mit einem zur Zündschutzart passenden Mechanismus zum Öffnen und Schließen konstruiert und umgesetzt werden.

Insbesondere bei einer druckfesten Kapselung ist eine solche zur Zündschutzart passende Konstruktion sehr aufwändig und besteht aus mindestens zwei Mechanismen: Zum einen einem Deckel, um den Anschlussraum der Zündschutzart entsprechend zu öffnen und wieder zu verschließen. Zum anderen Öffnungen für Kabelleitungen, um Kabel entsprechend in den Anschlussraum einzubringen. Beides erfordert Platz sowie konstruktiven Aufwand.

Da die Verkabelung in dem Anschlussraum eine Zündquelle darstellt, gelten dieselben Sicherheitsanforderungen an den Anschlussraum wie an den Aufnahmeraum. Daher sind derartige Gehäuse großvolumig und aufwendig in der Konstruktion.

Vor diesem Hintergrund ist es eine Aufgabe der vorgestellten Erfindung, eine Möglichkeit zum einfachen und sicheren Verkabeln eines in einem explosionsdruckfesten Gehäuse angeordneten Elektronikbauteils bereitzustellen.

Zur Lösung der voranstehend genannten Aufgabe wird somit gemäß einem ersten Aspekt der vorgestellten Erfindung ein Gehäuse zum Sichern von Zündquellen vorgestellt.

Das vorgestellte Gehäuse ist explosionsdruckfest gegen eine in dem Gehäuse stattfindende Explosion und umfasst einen Gehäusekörper, eine in den Gehäusekörper eingebrachte Öffnung zum Verbinden mit einer Kabelleitungseinführung und eine an dem Gehäusekörper angeordnete Schnittstelle zum Verbinden mit einem durch die Öffnung verlaufenden Kabel, wobei die Schnittstelle zwischen einer Kopplungsstellung und einer Ruhestellung beweglich ist und wobei die Schnittstelle in der Kopplungsstellung entlang einer Vertikalachse des Gehäusekörpers weiter von einem der Öffnung gegenüberliegenden Ende des Gehäusekörpers entfernt ist als in der Ruhestellung.

Die vorgestellte Erfindung basiert auf einer Schnittstelle zur Kopplung mit einem Kabel. Entsprechend ist die Schnittstelle dazu konfiguriert, mit einem Kabel elektrisch und mechanisch verbunden zu werden.

Optional kann die Schnittstelle dazu konfiguriert sein, mit einem zweiten, in dem Gehäuse angeordneten Kabel verbunden zu werden oder direkt ein Kabel umfassen, das in dem Gehäuse verläuft. Jedenfalls stellt die Schnittstelle eine Möglichkeit zum Übertragen von elektrischen Impulsen bzw. Signalen, insbesondere elektrischem Strom, in einen in dem Gehäuse gebildeten Aufnahmeraum bereit.

Die erfindungsgemäß vorgesehene Schnittstelle kann bspw. einen Anschluss, insbesondere eine Steckverbindung bzw. einen sogenannten "port" für ein Kabel, wie bspw. ein Ethernetkabel, ein Stromkabel, ein Koaxialkabel oder jedes weitere technisch geeignete Kabel zum Übertragen von elektrischen Impulsen bzw. Signalen an ein Elektronikbauteil umfassen.

Die erfindungsgemäß vorgesehene Schnittstelle ist derart an dem vorgestellten Gehäuse angeordnet, dass ein Kabel, dass durch eine in den Gehäusekörper des Gehäuses, insbesondere in einen Deckel bzw. ein Gehäuseelement des Gehäuses, eingebrachte Öffnung verläuft, zu der Schnittstelle geführt und mit dieser gekoppelt wird. Entsprechend kann das Kabel über die Schnittstelle mit einem in dem Gehäuse angeordneten Elektronikbauteil gekoppelt werden, ohne das Gehäuse zu öffnen. Ferner kann auf einen separaten bzw. zusätzlichen Anschlussraum zur Verkabelung verzichtet werden, so dass das Gehäuse besonders kleinvolumig und einfach konstruiert werden kann.

Bspw. kann der Gehäusekörper des vorgestellten Gehäuses einteilig bzw. monolithisch ausgestaltet sein. Ein einteiliges bzw. monolithisches Gehäuse ist besonders druckfest. Alternativ dazu kann das vorgestellte Gehäuse mehrteilig ausgestaltet sein und bspw. ein Gehäuseelement mit der Schnittstelle und einen an dem Gehäuseelement angeordneten Aufnahmeraum umfassen.

Um ein Koppeln eines durch die erfindungsgemäß vorgesehene Öffnung geführten Kabels mit der erfindungsgemäß vorgesehenen Schnittstelle ohne ein Öffnen des Gehäuses zu ermöglichen, ist die Schnittstelle zwischen einer Kopplungsstellung und einer Ruhestellung beweglich.

In der Kopplungsstellung ist die Schnittstelle entlang einer Vertikalachse des Gehäusekörpers weiter von einem der Öffnung gegenüberliegenden Ende des Gehäusekörpers entfernt als in der Ruhestellung. Dies bedeutet, dass die Schnittstelle in der Kopplungsstellung von außen bzw. außerhalb des Gehäuses zugänglich ist, so dass diese durch ein Kabel kontaktiert und mit diesem gekoppelt werden kann. Dabei kann die Schnittstelle, optional aus dem Gehäuse bzw. einer die Öffnung bildenden Gehäusebohrung herausstehen, d.h. gegenüber dem Gehäusekörper überstehen, oder in einen Randbereich des Gehäuses hervorstehen, so dass die Schnittstelle zusammen mit dem Gehäuse bzw. der Gehäusebohrung einen geführten Pfad für das Kabel bildet und ein in die Öffnung eingebrachtes Kabel sich zwangsweise in die Schnittstelle bewegt bzw. sich mit dieser koppelt.

In der Ruhestellung ist die Schnittstelle entlang einer Vertikalachse des Gehäusekörpers näher an einem der Öffnung gegenüberliegenden Ende des Gehäusekörpers als in der Kopplungsstellung. Entsprechend taucht die Schnittstelle in der Ruhestellung tiefer in das Gehäuse ein als in der Kopplungsstellung, so dass bspw. ein Raum über der Schnittstelle freigegeben wird, in den eine Schutzkappe eingebracht werden kann.

In der Ruhstellung ist eine Gegenschnittstelle des Kabels in das Gehäuse eingebracht, so dass die Gegenschnittstelle des Kabels sich zusammen mit der Schnittstelle des Gehäuses in dem Gehäuse befindet und entsprechend gesichert ist. Dazu kann in dem Gehäuse bspw. eine Schnittstelleaufnahme ausgebildet sein, in die die Schnittstelle und die Gegenschnittstelle in der Ruhstellung eingreifen. Entsprechend wird die Verkabelung tief in das Gehäuse verlagert und somit eine Umgebung des Gehäuses vor der Verkabelung geschützt.

Es kann vorgesehen sein, dass das Gehäuse die Zündschutzart "Druckfeste Kapselung", Ex "d", insbesondere die Norm IEC/EN/DIN 60079-1 erfüllt.

Ein Gehäuse, dass die Zündschutzart "Druckfeste Kapselung", Ex "d", insbesondere die Norm IEC/EN/DIN 60079-1 erfüllt, sichert eine Umgebung gegen eine in dem Gehäuse stattfindende Explosion, so dass die Explosion nicht auf die Umgebung übergeht und insbesondere in der Umgebung befindliche Fluide geschützt werden. Dazu kann das Gehäuse bspw. aus Metall bestehen und fluiddicht bzw. zünddurchschlagsicher abgedichtet sein.

Es kann weiterhin vorgesehen sein, dass das Gehäuse eine Kabelleitungseinführung umfasst, wobei die Kabelleitungseinführung die Zündschutzart "Druckfeste Kapselung", Ex "d", insbesondere die Norm IEC/EN/DIN 60079-1 erfüllt oder die Kabelleitungseinführung die Zündschutzart "Erhöhte Sicherheit", Ex "e", insbesondere die Norm IEC/EN/DIN 60079-7 erfüllt.

Durch eine Kabelleitungseinführung, die die Zündschutzart "Druckfeste Kapselung", Ex "d", insbesondere die Norm IEC/EN/DIN 60079-1 erfüllt, wird eine druckfeste Kapselung einer Schnittstelle eines Kabels in der Schnittstelle des Gehäuses erreicht. Dazu kann die Kabelleitungseinführung bspw. aus Metall bestehen und fluiddicht bzw. zünddurschlagsicher mit dem Gehäuse verbunden sein. Entsprechend kann durch die Ausgestaltung des Gehäuses und der Kabelleitungseinführung die Schnittstelle an sich unabhängig von einer jeweilig vorgegebenen Zündschutzart gestaltet werden, da diese durch die Kabelleitungseinführung sichergestellt wird.

Bei einer Kabelleitungseinführung, die die Zündschutzart "Erhöhte Sicherheit", Ex "e", insbesondere die Norm IEC/EN/DIN 60079-7 erfüllt, ist die Schnittstelle des Gehäuses derart ausgestaltet, dass diese die Zündschutzart "Druckfeste Kapselung", Ex "d", insbesondere die Norm IEC/EN/DIN 60079-1 erfüllt. Dazu kann die Schnittstelle bspw. aus Metall bestehen und/oder eine Hülle umfassen, die fluiddicht mit dem Gehäuse verbunden ist und einen beweglichen Teil umfassen, der beweglich und insbesondere fluiddicht bzw. zünddurchschlagsicher in der Hülle angeordnet ist. Entsprechend kann dadurch die Kabelleitungseinführung an sich unabhängig von der Zündschutzart bspw. aus einem Kunststoff gestaltet werden, da diese durch die Schnittstelle sichergestellt wird.

Es kann weiterhin vorgesehen sein, dass das Gehäuse lediglich einen Raum umfasst und, dadurch bedingt, ohne separaten Anschlussraum ausgeführt ist.

Ein einzelner Raum bzw. eine einzelne Aufnahme für ein Elektronikbauteil ermöglicht eine besonders kompakte und einfache anschlussraumlose Konstruktion des vorgestellten Gehäuses.

Es kann weiterhin vorgesehen sein, dass der Gehäusekörper eine lösbare Kappe umfasst, wobei die Öffnung in die Kappe eingebracht ist.

Eine lösbare Kappe ermöglicht das Einbringen eines Elektronikbauteils in das Gehäuse.

Es kann weiterhin vorgesehen sein, dass die Schnittstelle mindestens ein elastisches Element, insbesondere eine mechanische Feder umfasst, wobei das mindestens eine elastische Element die Schnittstelle von der Ruhestellung in Richtung der Kopplungsstellung drückt.

Ein elastisches Element, wie bspw. eine mechanische Feder, ermöglicht eine Bewegung der Schnittstelle von der Ruhestellung in die Kopplungsstellung, ohne dass das Gehäuse geöffnet werden muss.

Es kann weiterhin vorgesehen sein, dass die Schnittstelle einen push-push Mechanismus umfasst.

Zum Bereitstellen eines push-push Mechanismus kann ein weiteres elastisches Element vorgesehen sein, dass die Schnittstelle von der Kopplungsstellung in die Ruhestellung drückt. Dadurch kann ein Kabel sicher mit der Schnittstelle des Gehäuses gekoppelt und anschließend durch das weitere elastische Element in die Ruhestellung bewegt bzw. gedrückt werden.

Es kann weiterhin vorgesehen sein, dass die Schnittstelle in dem Gehäuse mit einer Kapsel umgeben ist, wobei die Kapsel eine Kabelleitungseinführung umfasst.

Eine Kapsel mit einer Kabelleitungseinführung stellt eine Hülle für die Schnittstelle bereits, so dass die Kapsel die Anforderungen an eine jeweilige Schutzart erfüllt und die Schnittstelle sowie ein jeweiliges Kabel unabhängig von der Schutzart ausgestaltet werden können.

Es kann weiterhin vorgesehen sein, dass die Schnittstelle einen zünddurchschlagsicheren Zylinderspalt und/oder Gewindespalt und/oder Flachspalt bildet.

Ein durch die Schnittstelle bzw. zwischen der Schnittstelle und dem Gehäuse gebildeter zünddurchschlagsicheren Zylinderspalt und/oder Gewindespalt und/oder Flachspalt ermöglicht die Verwendung eines von der Schutzart des Gehäuses unabhängige Ausgestaltung einer jeweiligen Kabelleitungseinführung, insbesondere eine Kabelleitungseinführung der Schutzart oder "erhöhte Sicherheit", Ex "e".

Es kann weiterhin vorgesehen sein, dass das Gehäuse ein Sicherungselement umfasst, dass die Schnittstelle in der Ruhestellung sichert, wobei die Schnittstelle zumindest teilweise um ihre Längsachse zwischen einer Sicherungsstellung und einer Freigabestellung beweglich ist, wobei die Schnittstelle in der Sicherungsstellung durch das Sicherungselement gegen eine Bewegung von der Ruhestellung in die Kopplungsstellung gesichert ist, und wobei die Schnittstelle in der Freigabestellung zwischen der Ruhestellung und der Kopplungsstellung frei beweglich ist.

Ein Sicherungselement das durch eine Längsdrehung der Schnittstelle in diese eingreifbar ist, ermöglicht ein einfaches reversibles Sichern der Schnittstelle in der Ruhestellung.

Gemäß einem zweiten Aspekt betrifft die vorgestellte Erfindung ein Verbindungsverfahren zum Verbinden einer in einem Gehäuse gesicherten Zündquelle mit einem Kabel.

Das vorgestellte Verbindungsverfahren umfasst das Bereitstellen einer möglichen Ausgestaltung des vorgestellten Gehäuses, das Bewegen der Schnittstelle von der Ruhestellung in die Kopplungsstellung, das Verbinden des Kabels mit der Schnittstelle und das Bewegen der Schnittstelle von der Kopplungsstellung in die Ruhestellung.

Das vorgestellte Gehäuse dient insbesondere zur Durchführung des vorgestellten Verbindungsverfahrens.

Es kann vorgesehen sein, dass das Kabel durch eine Kabelleitungseinführung geführt wird und die Kabelleitungseinführung mit dem Gehäuse verbunden wird.

Mittels einer Kabelleitungseinführung kann ein jeweiliges Kabel geführt und sicher an dem Gehäuse angeordnet werden. Dabei kann die Kabelleitungseinführung ggf. einer jeweiligen Schutzart entsprechend ausgelegt werden, so dass eine Schnittstelle des Kabels gegenüber einer Umgebung durch die Kabelleitungseinführung gesichert wird.

Es kann weiterhin vorgesehen sein, dass das Kabel zusammen mit zumindest einem Teil der Schnittstelle beim Bewegen der Schnittstelle von der Kopplungsstellung in die Ruhestellung um seine Längsachse gedreht wird, so dass die Schnittstelle in eine Sicherungsstellung bewegt wird, in der die Schnittstelle gegen ein Bewegen von der Ruhestellung in die Kopplungsstellung gesichert ist.

Eine Drehbewegung zum Sichern bzw. Entsichern eines jeweiligen Kabels in der Ruhestellung, ist einfach und schnell ausführbar. Insbesondere wird durch eine Drehbewegung zum Sichern bzw. Entsichern eines jeweiligen Kabels in der Ruhestellung ein Öffnen des Gehäuses zum Koppeln des Kabels mit der Schnittstelle des Gehäuses vermieden.

Gemäß einem dritten Aspekt betrifft die vorgestellte Erfindung ein Elektroniksystem. Das Elektroniksystem umfasst ein Elektronikbauteil, wie bspw. eine Kamera und/oder eine Leuchte und eine mögliche Ausgestaltung des vorgestellten Gehäuses, wobei das Elektronikbauteil in dem Gehäuse angeordnet und über die Schnittstelle des Gehäuses mit einem Kabel verbunden ist.

Aufgrund des vorgestellten Gehäuses sind sämtliche Zündquellen des vorgestellten Elektroniksystems in dem Gehäuse gesichert, insbesondere explosionsdruckfest gesichert.

Gemäß einem vierten Aspekt betrifft die vorgestellte Erfindung ein Gehäuseelement für ein Gehäuse zum Sichern von Zündquellen, wobei das Gehäuse explosionsdruckfest gegen eine in dem Gehäuse stattfindende Explosion ist.

Das Gehäuseelement umfasst einen Gehäuseelementkörper, eine in den Gehäuseelementkörper eingebrachte Öffnung zum Verbinden mit einer Kabelleitungseinführung und eine an dem Gehäuseelementkörper angeordnete Schnittstelle zum Verbinden mit einem durch die Öffnung verlaufenden Kabel, wobei die Schnittstelle zwischen einer Kopplungsstellung und einer Ruhestellung beweglich ist, und wobei die Schnittstelle in der Kopplungsstellung entlang einer Vertikalachse des Gehäuseelementkörpers weiter von einem der Öffnung gegenüberliegenden Ende des Gehäuseelementkörpers entfernt ist als in der Ruhestellung.

Das vorgestellte Gehäuseelement dient insbesondere zur Verbindung mit einem Grundkörper um ein explosionsdruckfestes Gehäuse zu bilden. Dazu kann das Gehäuseelement bspw. eine Kappe oder eine Aufnahmekammer eines Gehäuses bilden. Dazu kann das Gehäuseelement bspw. dazu konfiguriert sein, mit dem Gehäuse zusammen eine Zünddurchschlagsichere Barriere zu bilden.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:
- Fig. 1: eine mögliche Ausgestaltung des vorgestellten Elektroniksystems mit einer möglichen Ausgestaltung des vorgestellten Gehäuses mit einer möglichen Ausgestaltung des vorgestellten Gehäuseelements,
- Fig. 2: eine Detaildarstellung einer möglichen Ausgestaltung des vorgestellten Gehäuses,
- Fig. 3: eine Detaildarstellung einer weiteren möglichen Ausgestaltung des vorgestellten Gehäuses,
- Fig. 4: eine Darstellung einer möglichen Ausgestaltung des vorgestellten Verbindungsverfahrens.

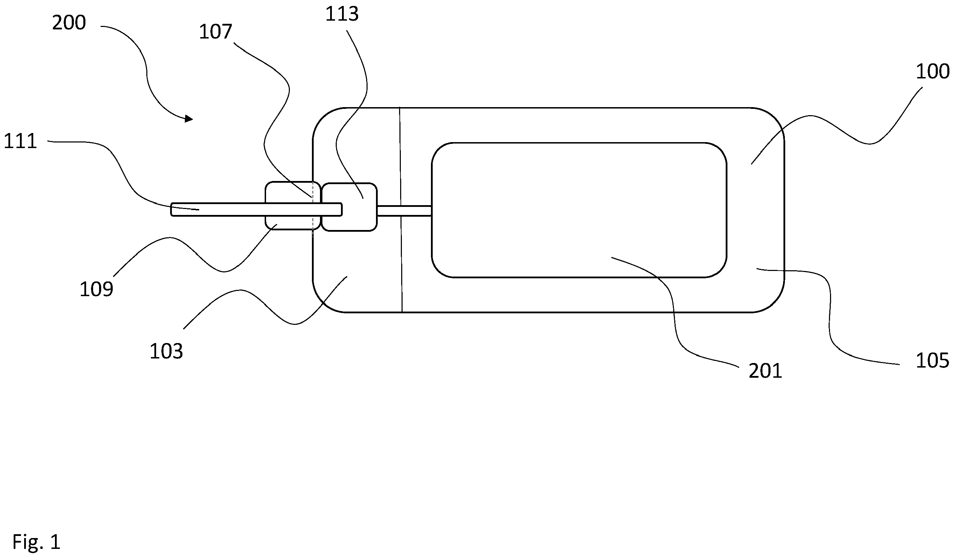

In Fig. 1 ist ein Elektroniksystem 200 dargestellt. Das Elektroniksystem 200 umfasst ein Gehäuse 100 zum Sichern von Zündquellen und ein Elektronikbauteil 201 in Form einer Kamera. Das Gehäuse 100 ist explosionsdruckfest gegen eine in dem Gehäuse 100 stattfindende Explosion und umfasst einen Gehäusekörper 101, der ein Gehäuseelement 103 in Form einer Kappe und einen Aufnahmeraum 105 umfasst.

In dem Gehäuseelement 103 ist eine Öffnung 107 zum Verbinden mit einer Kabelleitungseinführung 109 und zum Durchführen eines Kabels 111 ausgebildet. Ferner umfasst das Gehäuseelement 103 eine Schnittstelle 113 zum Verbinden mit dem Kabel 111.

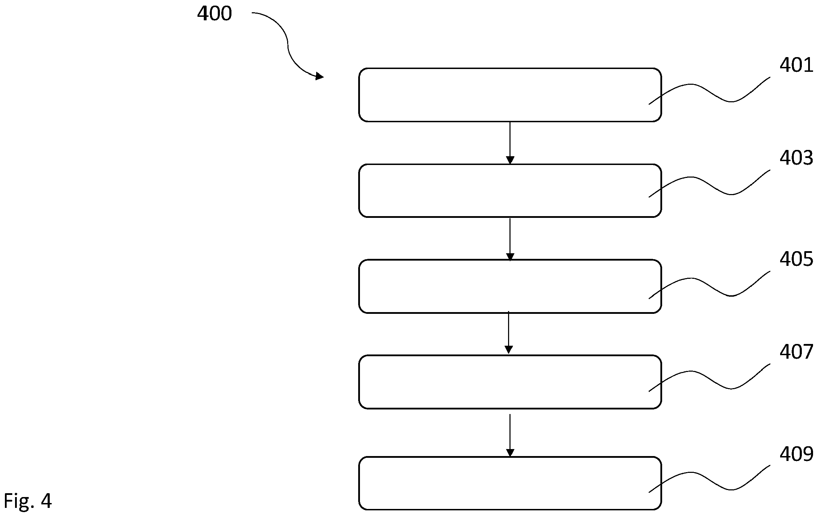

Die Schnittstelle 113 ist zwischen einer Kopplungsstellung und einer Ruhestellung beweglich, wie in Fig. 4 im Detail dargestellt. Entsprechend kann das Kabel 111 in der Kopplungsstellung einfach und schnell, ohne das Gehäuse 100 zu öffnen, mit der Schnittstelle 113 verbunden werden und ist in der Ruhestellung explosionsdruckfest in dem Gehäuse 100 gesichert.

Das Elektronikbauteil 201 ist über ein weiteres Kabel 127 mit der Schnittstelle 113 gekoppelt, so dass das Elektronikbauteil 201 über das Kabel 111 und das Kabel 127 mit elektrischen Signalen, insbesondere elektrischem Strom zur Energieversorgung versorgt werden kann.

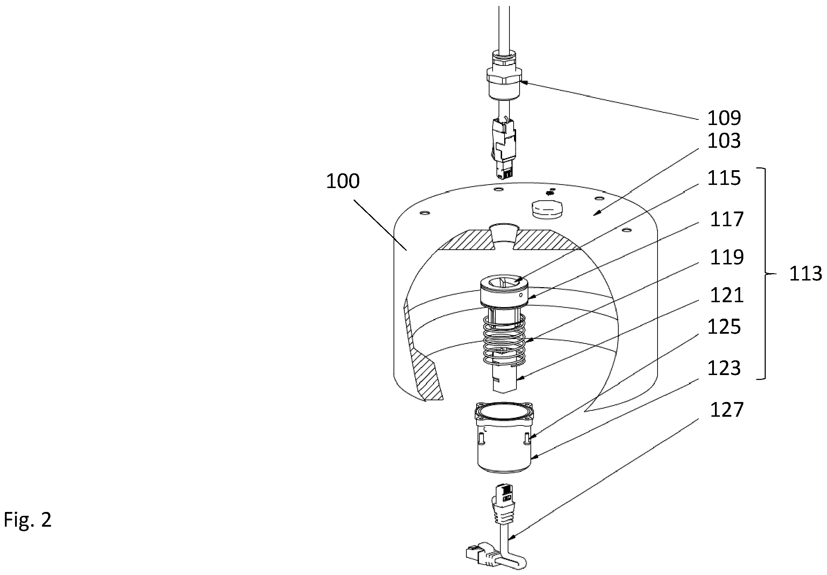

In Fig. 2 ist das Gehäuse 100 im Detail dargestellt. Hier ist die Schnittstelle 113 in einer Explosionsdarstellung mit ihren Komponenten gezeigt. Das Gehäuseelement 103 ist hier, ebenso wie eine optionale Kabelleitungseinführung 109 von der Schutzart "Ex-d" und entsprechend aus Metall gefertigt.

Die Schnittstelle 113 setzt sich zusammen aus einem Mantelelement 115, einer Dichtung 117, einer mechanischen Feder 119 einem Port 121 und einer Kapsel 123. Die Kapsel 123 ist durch Schrauben 125 an dem Mantelelement 115 gesichert.

Die Kapsel 123 umfasst eine Öffnung zum Durchführen des in dem Gehäuse 100 verlaufenden Kabels 127 zur Verbindung mit dem Elektronikbauteil 201.

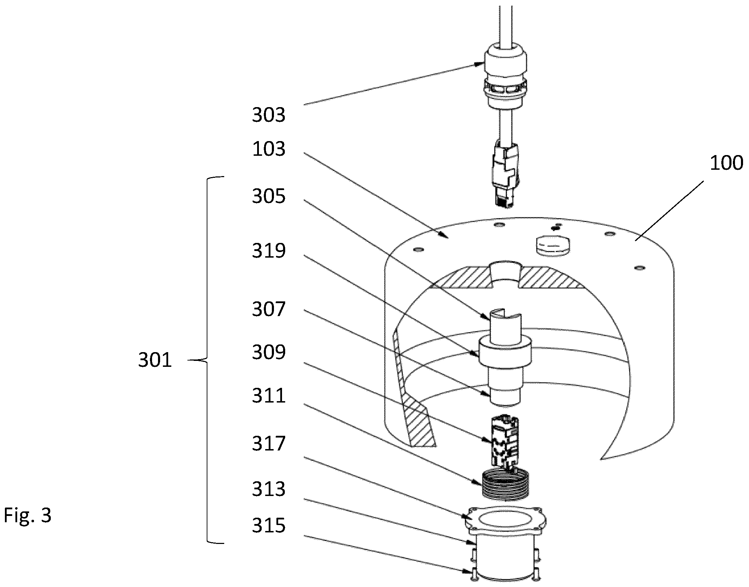

In Fig. 3 ist das Gehäuse 100 mit einer alternativen Schnittstelle 301 gezeigt. Das Gehäuseelement 103 ist hier von der Schutzart "Ex-d", wohingegen die optionale Kabelleitungseinführung 303 von der Schutzart "Ex-e" und bspw. aus Kunststoff gefertigt ist.

Die Schnittstelle 301 setzt sich zusammen aus einem metallenen Mantelelement 305, einer Vergussmasse 307, einem Ethernet-crimp Verbinder 309, einer mechanischen Feder 311 und einer metallischen Kapsel 313, die über Schrauben 315 an dem Mantelelement 305 gesichert ist und einen zünddurchschlagsicheren Spalt 317, insbesondere einen Flachspalt zu dem Mantelelement 305 ausbildet.

Auch das Mantelelement 305 bildet einen zünddurchschlagsicheren Spalt 319 zu dem Gehäuseelement 103 aus.

In Fig. 4 ist ein Verbindungsverfahren 400 dargestellt. Das Verbindungsverfahren 400 umfasst einen Bereitstellungsschritt 401, bei dem eine mögliche Ausgestaltung des vorgestellten Gehäuses, wie bspw. dem Gehäuse 100 gemäß Fig. 1 bereitgestellt wird.

In einem Bewegungsschritt 403 wird die Schnittstelle 113 des Gehäuses 100, wenn diese sich in ihrer Ruhestellung befindet, in ihre Kopplungsstellung bewegt, indem diese bspw. kurz gedrückt wird um einen push-push Mechanismus zu aktivieren.

Wenn die Schnittstelle 113 sich in ihrer Kopplungsstellung bewegt, wird ein Kabel 111 in einem Verbindungsschritt 405 mit der Schnittstelle 113 verbunden.

In einem Bewegungsschritt 407 wird das Kabel 111 zunächst um seine Längsachse, bspw. um 90° gedreht und in seine Ruhestellung bewegt, insbesondere gedrückt.

In einem Sicherungsschritt 409 wird eine Kabelleitungseinführung 109 auf das Gehäuse 100 geschraubt, die das Gehäuse 100 samt der Schnittstelle 113 explosionsdrucksicher sichert.

Die Erfindung ist nicht auf eine der vorbeschriebenen Ausführungsformen beschränkt, sondern in vielfältiger Weise abwandelbar.

Sämtliche aus den Ansprüchen, der Beschreibung und der Zeichnung hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

### Bezugszeichenliste

- 100: Gehäuse
- 101: Gehäusekörper
- 103: Gehäuseelement
- 105: Aufnahmeraum
- 107: Öffnung
- 109: Kabelleitungseinführung
- 111: Kabel
- 113: Schnittstelle
- 115: Mantelelement
- 117: Dichtung
- 119: Feder
- 121: Port
- 123: Kapsel
- 125: Schraube
- 127: Kabel
- 200: Elektroniksystem
- 201: Elektronikbauteil
- 301: Schnittstelle
- 303: Kabelleitungseinführung
- 305: Mantelelement
- 307: Vergussmasse
- 309: Ethernet crimp Verbinder
- 311: Feder
- 313: Kapsel
- 315: Schraube
- 317: zünddurchschlagsicherer Spalt
- 319: zünddurchschlagsicherer Spalt
- 400: Verbindungsverfahren
- 401: Bereitstellungsschritt
- 403: Bewegungsschritt
- 405: Verbindungsschritt
- 407: Bewegungsschritt
- 409: Sicherungsschritt

## Patentansprüche

1. Gehäuse (100) zum Sichern von Zündquellen,
wobei das Gehäuse (100) explosionsdruckfest gegen eine in dem Gehäuse (100) stattfindende Explosion ist, und
wobei das Gehäuse (100) umfasst:
- einen Gehäusekörper (101),
- eine in den Gehäusekörper (101) eingebrachte Öffnung (107) zum Verbinden mit einer Kabelleitungseinführung (109, 303),
- eine an dem Gehäusekörper (101) angeordnete Schnittstelle (113, 301) zum Verbinden mit einem durch die Öffnung (107) verlaufenden Kabel (127),
wobei die Schnittstelle (113, 301) zwischen einer Kopplungsstellung und einer Ruhestellung beweglich ist,
wobei die Schnittstelle (113, 301) in der Kopplungsstellung entlang einer Vertikalachse des Gehäusekörpers (101) weiter von einem der Öffnung (107) gegenüberliegenden Ende des Gehäusekörpers (100) entfernt ist als in der Ruhestellung.

2. Gehäuse (100) nach Anspruch 1,
**dadurch gekennzeichnet,**
**dass** das Gehäuse (100) die Zündschutzart "Druckfeste Kapselung", Ex "d", insbesondere die Norm EN 60079-1 erfüllt.

3. Gehäuse (100) nach Anspruch 1 oder 2,
**dadurch gekennzeichnet,**
**dass** das Gehäuse (100) eine Kabelleitungseinführung (109, 303) umfasst, wobei die Kabelleitungseinführung (109) die Zündschutzart "Druckfeste Kapselung", Ex "d", insbesondere die Norm EN 60079-1 erfüllt oder die Kabelleitungseinführung (303) die Zündschutzart "Erhöhte Sicherheit", Ex "e", insbesondere die Norm EN 60079-7 erfüllt

4. Gehäuse (100) nach einem der voranstehenden Ansprüche,
**dadurch gekennzeichnet,**
**dass** das Gehäuse (100) lediglich einen einzelnen Raum umfasst und, dadurch bedingt, ohne separaten Anschlussraum ausgeführt ist.

5. Gehäuse (100) nach einem der voranstehenden Ansprüche,
**dadurch gekennzeichnet,**
**dass** der Gehäusekörper (101) eine lösbare Kappe (103) umfasst,
wobei die Öffnung (107) in die Kappe (103) eingebracht ist.

6. Gehäuse (100) nach einem der voranstehenden Ansprüche,
**dadurch gekennzeichnet,**
**dass** die Schnittstelle (113, 301) mindestens ein elastisches Element, insbesondere eine mechanische Feder (119, 311) umfasst,
wobei das mindestens eine elastische Element die Schnittstelle (113, 301) von der Ruhestellung in Richtung der Kopplungsstellung drückt.

7. Gehäuse (100) nach einem der voranstehenden Ansprüche,
**dadurch gekennzeichnet,**
**dass** die Schnittstelle (113, 301) einen push-push Mechanismus umfasst.

8. Gehäuse (100) nach einem der voranstehenden Ansprüche,
**dadurch gekennzeichnet,**
**dass** die Schnittstelle (113, 301) in dem Gehäuse (100) mit einer Kapsel (123) umgeben ist, wobei die Kapsel eine Kabelleitungseinführung umfasst.

9. Gehäuse (100) nach einem der voranstehenden Ansprüche,
**dadurch gekennzeichnet,**
**dass** die Schnittstelle (113, 301) einen zünddurchschlagsicheren Zylinderspalt und/oder Gewindespalt und/oder Flachspalt bildet.

10. Gehäuse (100) nach einem der voranstehenden Ansprüche,
**dadurch gekennzeichnet,**
**dass** das Gehäuse (100) ein Sicherungselement umfasst, dass die Schnittstelle (113, 301) in der Ruhestellung sichert,
wobei die Schnittstelle (113, 301) zumindest teilweise um ihre Längsachse zwischen einer Sicherungsstellung und einer Freigabestellung beweglich ist,
wobei die Schnittstelle (113, 301) in der Sicherungsstellung durch das Sicherungselement gegen eine Bewegung von der Ruhestellung in die Kopplungsstellung gesichert ist, und
wobei die Schnittstelle (113, 301) in der Freigabestellung zwischen der Ruhestellung und der Kopplungsstellung frei beweglich ist.

11. Verbindungsverfahren (400) zum Verbinden einer in einem Gehäuse (100) gesicherten Zündquelle mit einem Kabel,
wobei das Verbindungsverfahren (400) umfasst:
- Bereitstellen (401) eines Gehäuses (100) nach einem der Ansprüche 1 bis 10,
- Bewegen (403) der Schnittstelle (113, 301) von der Ruhestellung in die Kopplungsstellung,
- Verbinden (405) des Kabels mit der Schnittstelle (113, 301),
- Bewegen (407) der Schnittstelle (113, 301) von der Kopplungsstellung in die Ruhestellung.

12. Verbindungsverfahren (400) nach Anspruch 11,
**dadurch gekennzeichnet,**
**dass** das Kabel durch eine Kabelleitungseinführung (109, 303) geführt wird und die Kabelleitungseinführung (109, 303) mit dem Gehäuse (100) verbunden wird.

13. Verbindungsverfahren (400) nach Anspruch 11 oder 12,
**dadurch gekennzeichnet,**
**dass** das Kabel zusammen mit zumindest einem Teil der Schnittstelle (113, 301) beim Bewegen der Schnittstelle (113, 301) von der Kopplungsstellung in die Ruhestellung um seine Längsachse gedreht wird, so dass die Schnittstelle in eine Sicherungsstellung bewegt wird, in der die Schnittstelle (113, 301) gegen ein Bewegen von der Ruhestellung in die Kopplungsstellung gesichert ist.

14. Elektroniksystem (200),
wobei das Elektroniksystem (200) umfasst:
- ein Elektronikbauteil (201),
- ein Gehäuse (100) nach einem der Ansprüche 10,
wobei das Elektronikbauteil (201) in dem Gehäuse (100) angeordnet und über die Schnittstelle (113, 301) des Gehäuses (100) mit einem Kabel verbunden ist.

15. Gehäuseelement (103) für ein Gehäuse (100) zum Sichern von Zündquellen, wobei das Gehäuse (100) explosionsdruckfest gegen eine in dem Gehäuse (100) stattfindende Explosion ist, und
wobei das Gehäuseelement (103) umfasst:
- einen Gehäuseelementkörper (101),
- eine in den Gehäuseelementkörper (101) eingebrachte Öffnung (107) zum Verbinden mit einer Kabelleitungseinführung (109, 303),
- eine an dem Gehäuseelementkörper (101) angeordnete Schnittstelle (113, 301) zum Verbinden mit einem durch die Öffnung (107) verlaufenden Kabel (111), wobei die Schnittstelle (113, 301) zwischen einer Kopplungsstellung und einer Ruhestellung beweglich ist,
wobei die Schnittstelle (113, 301) in der Kopplungsstellung entlang einer Vertikalachse des Gehäuseelementkörpers (101) weiter von einem der Öffnung gegenüberliegenden Ende des Gehäuseelementkörpers (101) entfernt ist als in der Ruhestellung.
